# EUROPEAN PATENT APPLICATION

(11) **EP 4 596 159 A1**
(43) Date of publication of application: **06.08.2025**
(21) Application number: 24220162.2
(22) Date of filing: 16.12.2024
(51) Int. Cl.: B23K 26/0622, B23K 26/06, B23K 26/064, B23K 26/067, B23K 26/352, B23K 26/362

(54) **LASER PROCESSING MACHINE, SPACE TRANSMISSION DEVICE, AND SPACE TRANSMISSION METHOD**

(30) Priority: 31.01.2024 JP 2024013782
(71) Applicant: Kataoka Corporation, Kyoto-shi, Kyoto 601-8203 (JP)
(72) Inventor: SHIBUTANI, Ryo, Kyoto 601-8203 (JP); MIYAI, Ryuichi, Kyoto 601-8203 (JP); KATO, Etsushi, Kyoto 601-8203 (JP)
(74) Representative: Seemann & Partner Patentanwälte mbB

(57) **Abstract**

A space transmission (9a, 9b) device used in a laser processing machine. The laser processing machine including a laser oscillator (8) configured to oscillate a laser beam having a pulse width in a picosecond order or a femtosecond order, and a plurality of irradiation units (10a, 10b). The space transmission device includes an optical member configured to change a beam diameter of the laser beam, on an optical path of the laser beam that is emitted from the laser oscillator and that is incident on any one of the plurality of irradiation units.

## Description

### TECHNICAL FIELD

The present disclosure relates to a laser processing machine for patterning a thin film solar cell.

### BACKGROUND ART

In a process of manufacturing a thin film solar cell, several hundred patterning processing are performed on a film-like substrate by a laser processing machine. Usually, a plurality of processing heads are arranged to simultaneously perform a plurality of patterning processing in order to improve productivity, and the number of processing heads that can be arranged in a space is limited, and thus the several hundred patterning processing can be efficiently performed by causing a film to be processed or the processing heads to reciprocate (for example, see JP2012-66281A).

In recent years, perovskite-type solar cell panels have been developed instead of silicon-type solar cell panels in the related art. In patterning processing of the perovskite-type solar cell, in order to improve processing quality or narrow a processing line width, high-output ultrashort pulse lasers (picosecond laser, femtosecond laser, and the like) are used instead of a nanosecond laser in the related art. The ultrashort pulse lasers have less thermal influence on the panel as compared with the nanosecond laser, and are suitable for high-precision micro-processing.

However, the ultrashort pulse laser is not suitable for fiber transmission because the ultrashort pulse laser is likely to cause fiber breakage or laser change. In general, a laser is transmitted by using a space transmission method. Therefore, an optical path length from an oscillator to the processing head becomes long.

As described above, in the case in which the ultrashort pulse laser is used in the laser processing machine including the plurality of processing heads, it is necessary to branch a plurality of laser beams to be spatially transmitted and transmit the branched laser beams to each processing head, which is likely to be affected by a change in a laser state because the optical path length is long, and a structure is also complicated.

### SUMMARY OF INVENTION

Aspect of non-limiting embodiments of the present disclosure relates to provide a laser processing machine capable of maintaining constant processing quality in a plurality of axes while reducing a change in a laser state with a space transmission device having a simple configuration.

Aspects of certain non-limiting embodiments of the present disclosure address the features discussed above and/or other features not described above. However, aspects of the non-limiting embodiments are not required to address the above features, and aspects of the non-limiting embodiments of the present disclosure may not address features described above.

According to an aspect of the present disclosure, there is provided a space transmission device used in a laser processing machine, the laser processing machine including a laser oscillator configured to oscillate a laser beam having a pulse width in a picosecond order or a femtosecond order, and a plurality of irradiation units,
the space transmission device including:
an optical member configured to change a beam diameter of the laser beam, on an optical path of the laser beam that is emitted from the laser oscillator and that is incident on any one of the plurality of irradiation units.

According to an aspect of the present disclosure, there is provided a space transmission device used in a laser processing machine, the laser processing machine including a laser oscillator configured to oscillate a laser beam having a pulse width in a picosecond order or a femtosecond order, and a plurality of irradiation units, the space transmission device including:
an attenuator configured to change a transmittance of the laser beam, on an optical path of the laser beam that is emitted from the laser oscillator and that is incident on any one of the plurality of irradiation units.

According to an aspect of the present disclosure, there is provided a laser processing machine including:
a laser oscillator configured to oscillate a laser beam having a pulse width in a picosecond order or a femtosecond order;
a plurality of first irradiation units configured to irradiate a workpiece with the laser beam; and
a beam transmission unit configured to spatially transmit the laser beam from the laser oscillator to the plurality of the first irradiation units,
in which the beam transmission unit includes an optical member configured to change a beam diameter of the laser beam, on an optical path of the laser beam that is emitted from the laser oscillator and that is incident on any one of the plurality of the first irradiation units.

According to an aspect of the present disclosure, there is provided a space transmission method used in a laser processing machine, the laser processing machine including a laser oscillator configured to oscillate a laser beam having a pulse width in a picosecond order or a femtosecond order, and a plurality of irradiation units,
the space transmission method including:
changing a beam diameter of the laser beam, on an optical path of the laser beam emitted from the laser oscillator and incident on any one of the plurality of irradiation units.

According to an aspect of the present disclosure, there is provided a space transmission method used in a laser processing machine, the laser processing machine including a laser oscillator configured to oscillate a laser beam having a pulse width in a picosecond order or a femtosecond order, and a plurality of irradiation units,
the space transmission method including:
changing a transmittance of the laser beam, on an optical path of the laser beam emitted from the laser oscillator is incident on any one of the plurality of irradiation units.

### BRIEF DESCRIPTION OF DRAWINGS

Exemplary embodiment(s) of the present invention will be described in detail based on the following figures, wherein:
FIG. 1 is a diagram illustrating a configuration of a laser processing machine 1 according to an embodiment.
FIG. 2 is a diagram illustrating a film to be processed 51, vertical processing, and horizontal processing.
FIG. 3 is a perspective view illustrating a configuration of a laser device 3.
FIG. 4 is a top view illustrating the configuration of the laser device 3.
FIG. 5 is a diagram illustrating a configuration of a vertical processing beam transmission unit 9a and a horizontal processing beam transmission unit 9b.
FIG. 6 is a diagram illustrating an optical path during vertical processing.
FIG. 7 is a diagram illustrating an optical path during horizontal processing.
FIG. 8 is a functional block diagram illustrating a functional configuration of a control device 5.
FIG. 9 is a diagram illustrating laser processing made by a plurality of vertical processing irradiation units 10a.
FIG. 10A is a diagram illustrating position correction of a laser irradiation position.
FIG. 10B is a diagram illustrating the position correction of the laser irradiation position.
FIG. 11 is a flowchart illustrating an operation of laser processing made by the laser processing machine 1.
FIG. 12 is a flowchart illustrating an operation of vertical processing made by the laser processing machine 1.

### DESCRIPTION OF EMBODIMENTS

### <Overview>

A space transmission device according to one aspect of the present disclosure is a space transmission device used in a laser processing machine, the laser processing machine including a laser oscillator configured to oscillate a laser beam having a pulse width in a picosecond order or a femtosecond order, and a plurality of irradiation units,
the space transmission device including:
an optical member configured to change a beam diameter of the laser beam, on an optical path of the laser beam that is emitted from the laser oscillator and that is incident on any one of the plurality of irradiation units.

In the space transmission device according to another aspect of the present disclosure, the optical member includes a plurality of lenses, and
the optical member is configured to generate collimated beam within a predetermined distance.

A space transmission device according to one aspect of the present disclosure is a space transmission device used in a laser processing machine, the laser processing machine including a laser oscillator configured to oscillate a laser beam having a pulse width in a picosecond order or a femtosecond order, and a plurality of irradiation units,
the space transmission device including:
an attenuator configured to change a transmittance of the laser beam, on an optical path of the laser beam that is emitted from the laser oscillator and that is incident on any one of the plurality of irradiation units.

In the space transmission device according to another aspect of the present disclosure, the attenuator includes a wave plate and a beam splitter, and
the attenuator is configured to change a transmittance of the laser beam, based on a total output of the laser beam required in the plurality of irradiation units.

A laser processing machine according to one aspect of the present disclosure includes: a laser oscillator configured to oscillate a laser beam having a pulse width in a picosecond order or a femtosecond order;
a plurality of first irradiation units configured to irradiate a workpiece with the laser beam; and
a beam transmission unit configured to spatially transmit the laser beam from the laser oscillator to the plurality of the first irradiation units,
in which the beam transmission unit includes an optical member configured to change a beam diameter of the laser beam, on an optical path of the laser beam that is emitted from the laser oscillator and that is incident on any one of the plurality of the first irradiation units.

The laser processing machine according to another aspect of the present disclosure further includes: a drive mechanism configured to displace a position of the optical member; and
a beam diameter controller configured to control the drive mechanism to displace the position of the optical member to adjust, to a predetermined beam diameter, the beam diameter of the laser beam incident on any one of the plurality of the first irradiation units.

In the laser processing machine according to another aspect of the present disclosure, the beam transmission unit includes an attenuator configured to change a transmittance of the laser beam, on the optical path of the laser beam emitted from the laser oscillator and incident on any one of the plurality of the first irradiation units, and
the laser processing machine further comprises a first laser power controller configured to change a transmittance of the attenuator based on a total output of the laser beam required in the plurality of the first irradiation units to control a power of the laser beam to be transmitted.

In the laser processing machine according to another aspect of the present disclosure, each of the plurality of the first irradiation units includes:
a processing nozzle that faces the workpiece and that is configured to output the laser beam toward the workpiece; and
an adjustment mechanism configured to substantially uniformly adjust a power of the laser beam to be output from each processing nozzle.

In the laser processing machine according to another aspect of the present disclosure, each of the adjustment mechanisms includes a wave plate and a beam splitter, and
the laser processing machine further comprises:
at least one power meter configured to measure the power of the laser beam to be output from the respective processing nozzle of the plurality of the first irradiation units; and
a second laser power controller configured to control the wave plate and the beam splitter provided in each of the plurality of the first irradiation units, based on an output value of the laser beam measured by the power meter, to adjust a laser power of each the plurality of the first irradiation units.

In the laser processing machine according to another aspect of the present disclosure, the plurality of the first irradiation units are arranged in series with respect to an optical axis of the laser beam, and
the laser processing machine further comprises a beam damper configured to absorb excess laser beam after the irradiation with laser by an irradiation unit located at a most downstream of the optical axis of the laser beam position among the plurality of the first irradiation units.

In the laser processing machine according to another aspect of the present disclosure, the workpiece is a film formed by stacking a plurality of layers,
each of the plurality of the first irradiation units further includes a camera configured to capture an image of the film, and
the laser processing machine further comprises a laser irradiation position controller configured to determine a laser irradiation position of each of the plurality of the first irradiation units, based on a laser processing line of a lower layer included in an image captured by the camera.

In the laser processing machine according to another aspect of the present disclosure, the laser irradiation position controller includes a memory configured to store a predetermined laser irradiation position of each of the plurality of the first irradiation units in advance, and
the laser irradiation position controller is configured to correct the predetermined laser irradiation position stored in advance in the memory such that the predetermined laser irradiation position follows the laser processing line of the lower layer included in the image captured by the camera.

In the laser processing machine according to another aspect of the present disclosure, the plurality of the first irradiation units are scattered in a direction intersecting a film conveyance direction, and are configured to be individually moved in the same direction by the drive mechanism, and
the laser irradiation position controller is configured to control the drive mechanism such that each of the plurality of the first irradiation units processes the corrected laser irradiation position.

In the laser processing machine according to another aspect of the present disclosure, each of the plurality of first irradiation units further includes a mirror configured to change the optical axis of the laser beam emitted from the processing nozzle, and
the laser irradiation position controller controls an orientation of the mirror such that each of the plurality of the first irradiation units processes the corrected laser irradiation position.

The laser processing machine according to another aspect of the present disclosure, the plurality of the first irradiation units are scattered in a direction intersecting a scanning direction of the laser beam, and are configured to be moved in the same direction, and
each of the plurality of the first irradiation units is configured to perform a plurality of patterning processing parallel to the film conveyance direction on the film.

The laser processing machine according to another aspect of the present disclosure further includes: a second irradiation unit that is disposed at a position spaced apart from the plurality of the first irradiation units and is configured to perform patterning processing in the direction intersecting the film conveyance direction; and
a second beam transmission unit configured to spatially transmit the laser beam from the laser oscillator to the second irradiation unit.

In the laser processing machine according to another aspect of the present disclosure, the second beam transmission unit includes a second optical member configured to change a beam diameter of the laser beam, on an optical path of the laser beam emitted from the laser oscillator and incident on the second irradiation unit.

The laser processing machine according to another aspect of the present disclosure further includes: a drive mechanism configured to displace a position of the second optical member; and
a beam diameter controller configured to control the drive mechanism to displace the position of the optical member to adjust, to a predetermined beam diameter, the beam diameter of the laser beam incident on the second irradiation unit.

The laser processing machine according to another aspect of the present disclosure further includes: an optical path switching unit configured to guide the laser beam emitted from the laser oscillator to any one of the plurality of the first irradiation units or the second irradiation unit.

A space transmission method according to one aspect of the present disclosure is a space transmission method used in a laser processing machine, the laser processing machine including a laser oscillator configured to oscillate a laser beam having a pulse width in a picosecond order or a femtosecond order, and a plurality of irradiation units,
the space transmission method including:
changing a beam diameter of the laser beam, on an optical path of the laser beam emitted from the laser oscillator and incident on any one of the plurality of irradiation units.

A space transmission method according to one aspect of the present disclosure is a space transmission method used in a laser processing machine, the laser processing machine including a laser oscillator configured to oscillate a laser beam having a pulse width in a picosecond order or a femtosecond order, and a plurality of irradiation units,
the space transmission method including:
changing a transmittance of the laser beam, on an optical path of the laser beam emitted from the laser oscillator is incident on any one of the plurality of irradiation units.

### <Embodiment>

Here, a laser processing machine 1 according to an embodiment of the present disclosure will be described in detail with reference to the drawings.

### 1. Process of Manufacturing Thin Film Solar Cell

The laser processing machine 1 is used in a process of manufacturing a thin film solar cell as an example. The process of manufacturing a thin film solar cell includes the following steps (a) to (f). (a) forming a first electrode film; (b) forming a separation groove of the first electrode film (P1 processing); (c) forming a power generation layer; (d) forming a separation groove of the power generation layer (P2 processing); (e) forming a second electrode film; and (f) forming a separation groove of the second electrode film (P3 processing). The laser processing machine 1 is a device configured to perform the P1 processing, the P2 processing, and the P3 processing. The laser processing machine 1 is configured to cut and form a plurality of separation grooves that divide the respective layers formed in the previous step into cell units by irradiating the respective layers with a laser beam. Cutting and forming the separation grooves with the laser beam may be referred to as "patterning processing" or "scribing processing". In the present embodiment, a film-type perovskite solar cell will be described as an example of a thin film solar cell.

### 2. Configuration of Laser Processing Machine 1

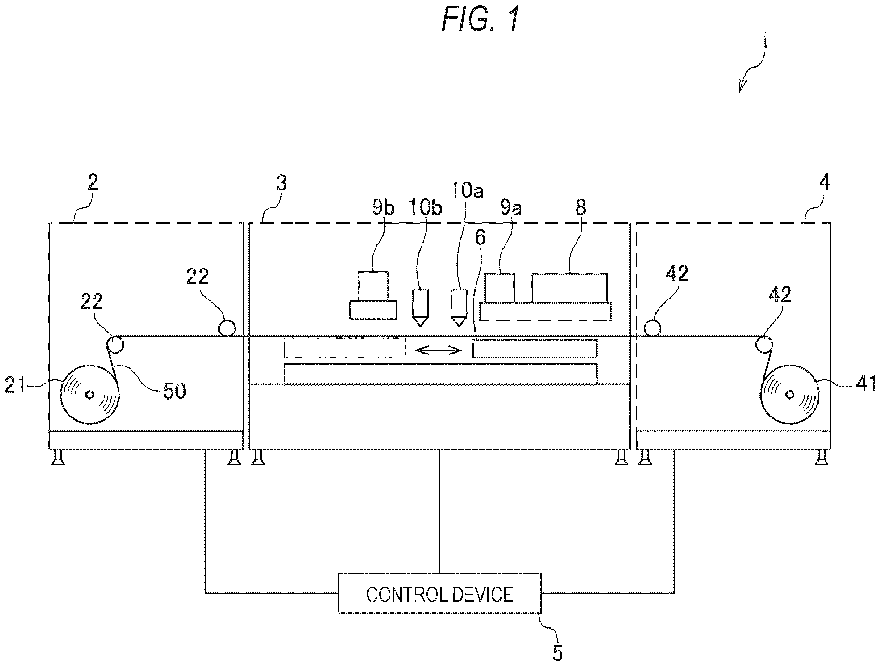

FIG. 1 is a schematic diagram illustrating an overall configuration of the laser processing machine 1 according to the present embodiment. In the present embodiment, a high-output ultrashort pulse laser is used as the laser oscillator 8. The high-output ultrashort pulse laser has a high peak output, and thus is likely to cause fiber breakage or laser change, which is not suitable for fiber transmission. If a photonic crystal fiber (PCF) is used, the fiber transmission may be performed depending on a wavelength of the laser beam to be used. A laser beam having a short wavelength of 532 nm or less is difficult to perform fiber transmission.

Therefore, the laser processing machine 1 according to the present embodiment uses a space transmission method. In the case of the space transmission method, optical path lengths from the laser oscillator 8 to an irradiation unit 10a and an irradiation unit 10b are long, laser quality such as a beam size becomes unstable, and a configuration of an optical device becomes complicated. Accordingly, the number of objects to be operated by a servo motor increases, and thus various technical problems such as optical axis deviation and tact delay due to insufficient capacity or vibration of the servo motor occur.

In the present embodiment, the laser processing machine 1 that solves such technical problems and implements high-quality patterning processing will be described.

As illustrated in FIG. 1, the laser processing machine 1 is a Roll-to-Roll device that performs patterning processing on an upper surface of a film using a laser device 3 while conveying a long film 50 from an upstream unwinding device 2 to a downstream winding device 4. A control device 5 is a computer system configured to control the unwinding device 2, the laser device 3, and the winding device 4.

The unwinding device 2 includes an unwinding shaft 21 and guide rolls 22. Similarly, the winding device 4 includes a winding shaft 41 and guide rolls 42. The guide rollers 22 and 42 is configured to reduce a tension applied to a substrate (film 50) and serve as guides during film conveyance.

The unwinding device 2 and the winding device 4 may include other components such as a servo motor, a tension measuring device, and a control panel for controlling each component, in addition to these components.

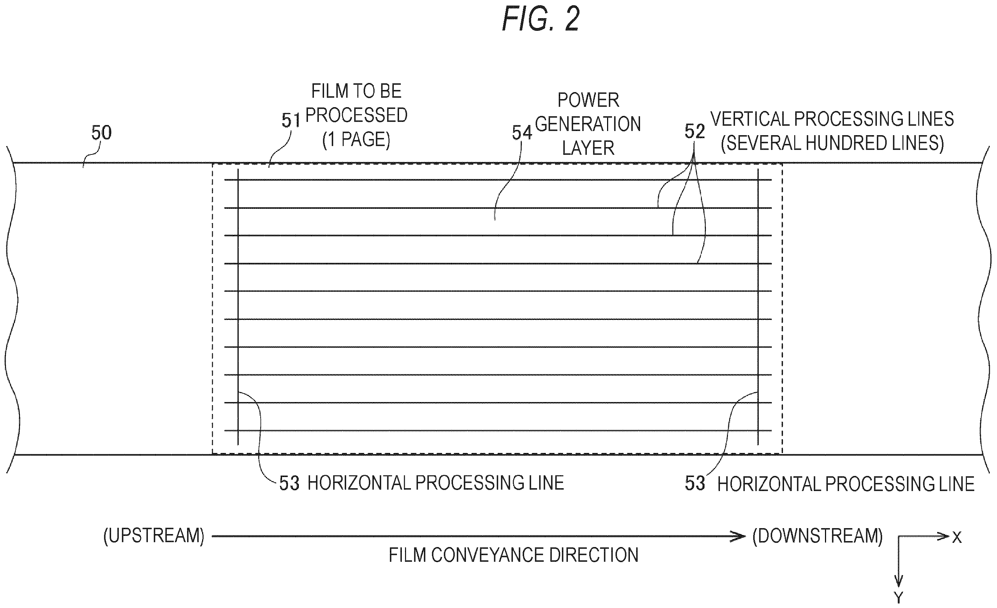

As illustrated in FIG. 2, the laser processing machine 1 is configured to perform patterning processing for each predetermined unit of the long film 50. The predetermined unit of the film 50 is referred to as a film to be processed 51. The laser processing machine 1 is configured to perform vertical processing of cutting several hundreds of grooves (vertical processing lines 52) in a direction (X-axis direction) horizontal to a film conveyance direction with respect to the film to be processed 51, and horizontal processing of cutting one or two grooves (horizontal processing lines 53) in a direction (Y-axis direction) intersecting the film conveyance direction.

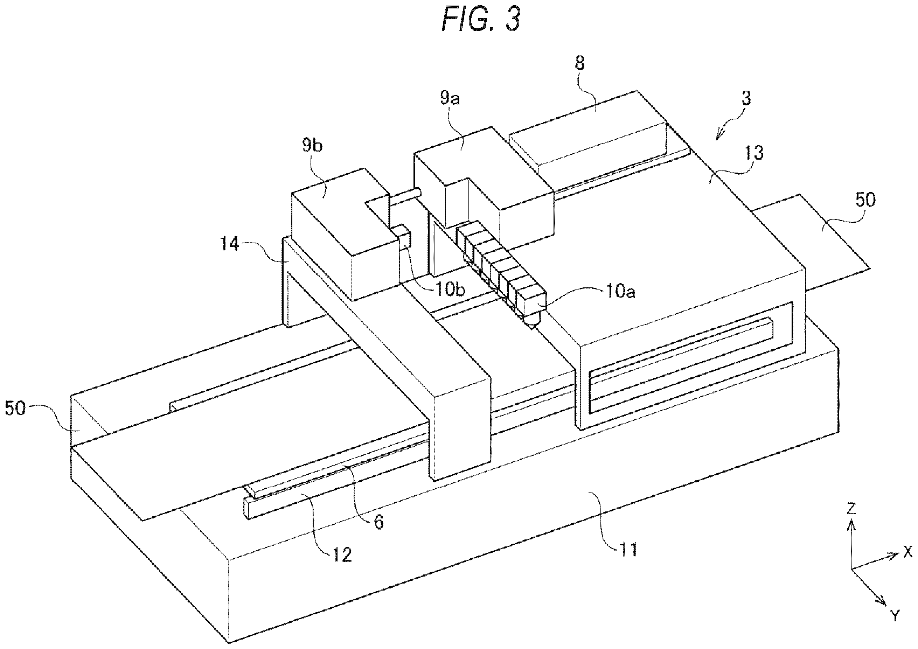

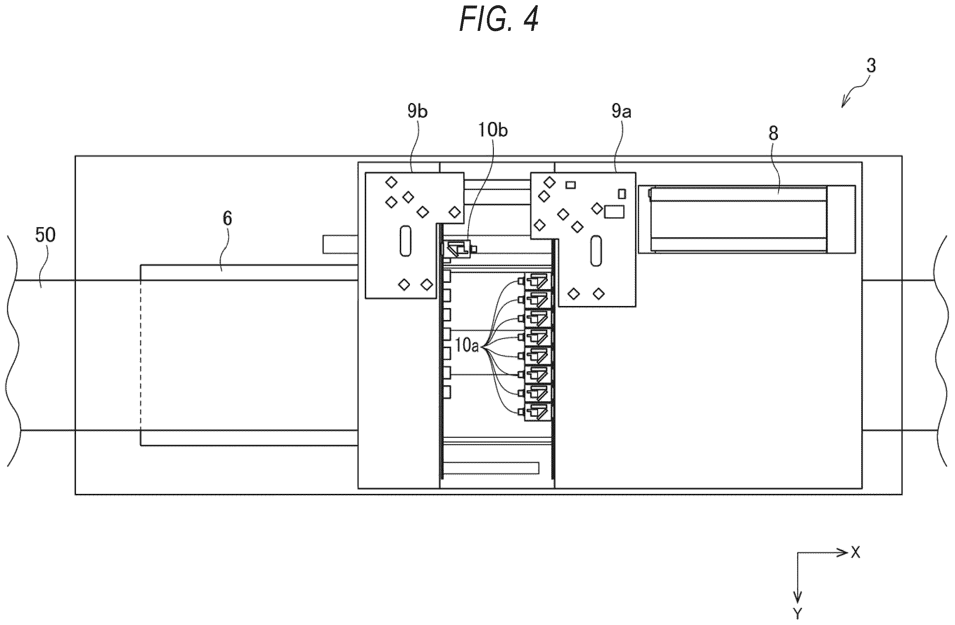

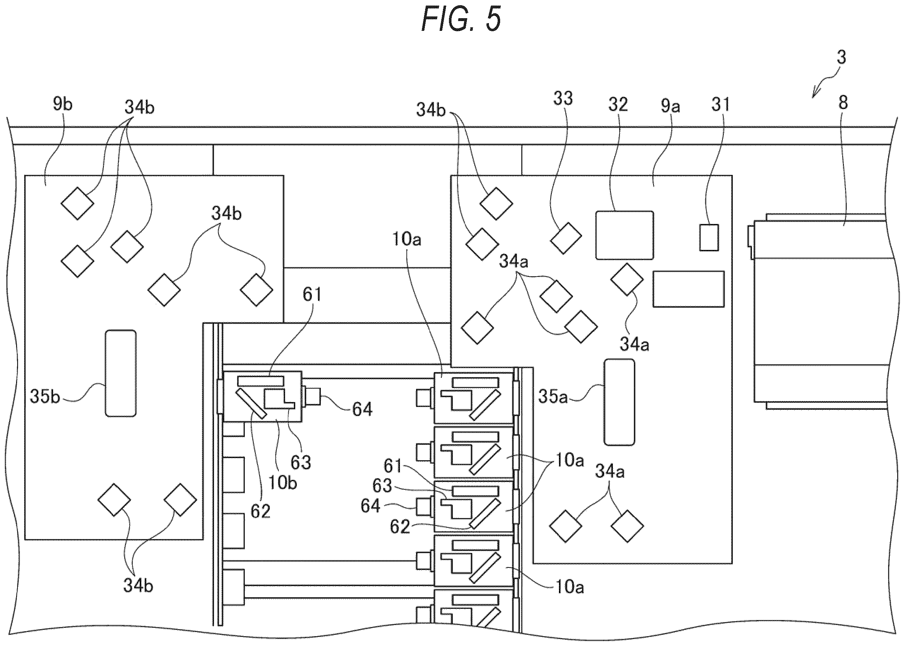

As illustrated in FIGS. 3 and 4, the laser device 3 includes two parallel rails 12 supported by a main body 11, a holding table 6 configured to be moved in the X-axis direction on the two rails 12, the laser oscillator 8 and a vertical processing beam transmission unit 9a that are fixed to a support table 13, a plurality of vertical processing irradiation units 10a configured to be moved in the Y-axis direction by being movably attached to a rail attached to the support table 13, a horizontal processing beam transmission unit 9b fixed to a support table 14, and one horizontal processing irradiation unit 10b configured to be moved in the Y-axis direction by being movably attached to a rail attached to the support table 14. Although the vertical processing beam transmission unit 9a, the horizontal processing beam transmission unit 9b, the irradiation units 10a, and the irradiation unit 10b are each housed within a housing, an upper surface of the housing is removed for convenience of description in FIGS. 4 and 5.

The holding table 6 has a rectangular shape in a plan view. The holding table 6 has a size equal to or larger than that of the film to be processed 51. The holding table 6 is configured to hold the film 50.

The laser oscillator 8 is a semiconductor laser configured to oscillate an ultrashort pulse laser beam having a pulse width in a picosecond order or a femtosecond order. The laser beam may be a blue laser or a green laser having a wavelength of 400 nm to 532 nm, or may be a red laser having a wavelength of 1,064 nm.

The vertical processing beam transmission unit 9a is configured to spatially transmit the laser beam emitted from the laser oscillator 8 to the irradiation units 10a. The horizontal processing beam transmission unit 9b is configured to spatially transmit the laser beam emitted from the laser oscillator 8 to the irradiation unit 10b. The vertical processing beam transmission unit 9a and the horizontal processing beam transmission unit 9b include a plurality of optical components, in order to prevent a decrease in beam quality while performing spatial transmission through a long optical path.

As illustrated in FIG. 5, the vertical processing beam transmission unit 9a includes a power meter 31, an attenuator 32, an optical path switching mirror 33, a plurality of folding mirrors 34a, and a beam expander 35a, which are arranged on the substrate. The horizontal processing beam transmission unit 9b includes a plurality of folding mirrors 34b and a beam expander 35b, which are arranged on the substrate.

The power meter 31 is configured to receive the laser beam emitted from the laser oscillator 8 and configured to measure an output. The attenuator 32 is configured to adjust a transmittance of the incident laser beam to adjust the output. The attenuator 32 includes, as an example, a wave plate, a polarized beam splitter, and a rotation mechanism unit for rotating the wave plate. The optical path switching mirror 33 includes a rotation mechanism unit and a mirror attached to the rotation mechanism unit. In a case where the rotation mechanism unit is controlled by the control device 5 to be described later, the optical path of the laser beam emitted from the laser oscillator 8 is switched. The folding mirrors 34a and 34b is configured to reflect the laser beam to change the optical path by 90 degrees. In the above rotation mechanism unit, a general mirror holder including an adjustment unit that can be adjusted in a vertical direction and a horizontal direction with reference to a fulcrum can be used.

The beam expanders 35a and 35b include a plurality of lenses. The beam expanders 35a and 35b is configured to enlarge or reduce a diameter of the incident laser beam. The beam expanders 35a is configured to form collimated beam. The beam expanders 35a and 35b may include a drive mechanism configured to displace positions of the plurality of lenses. The positions of the respective lenses may be displaced by the control device 5. In a case where no drive mechanism is provided in the beam expanders 35a and 35b, a user may manually displace the positions of the lenses.

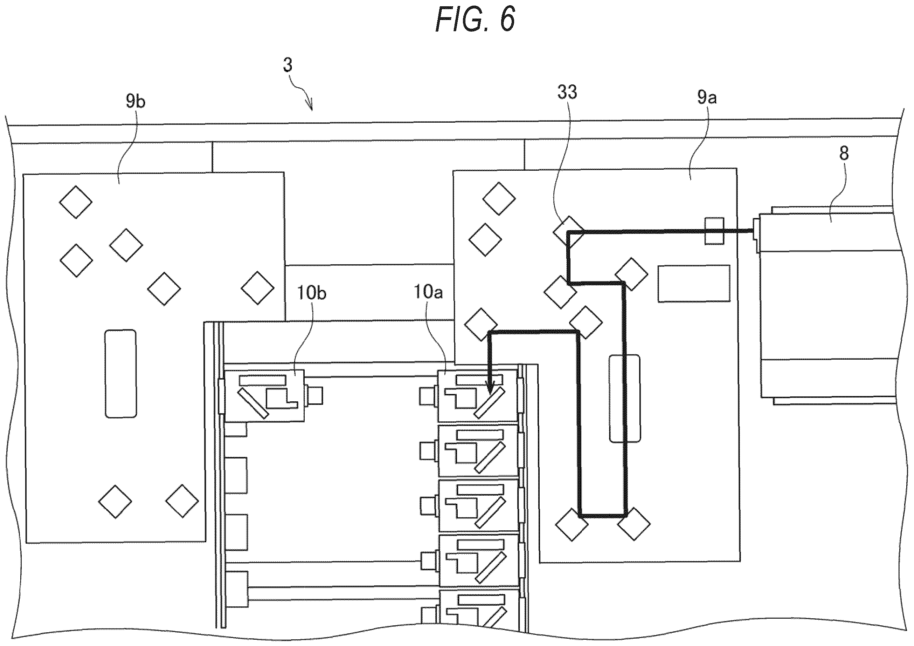

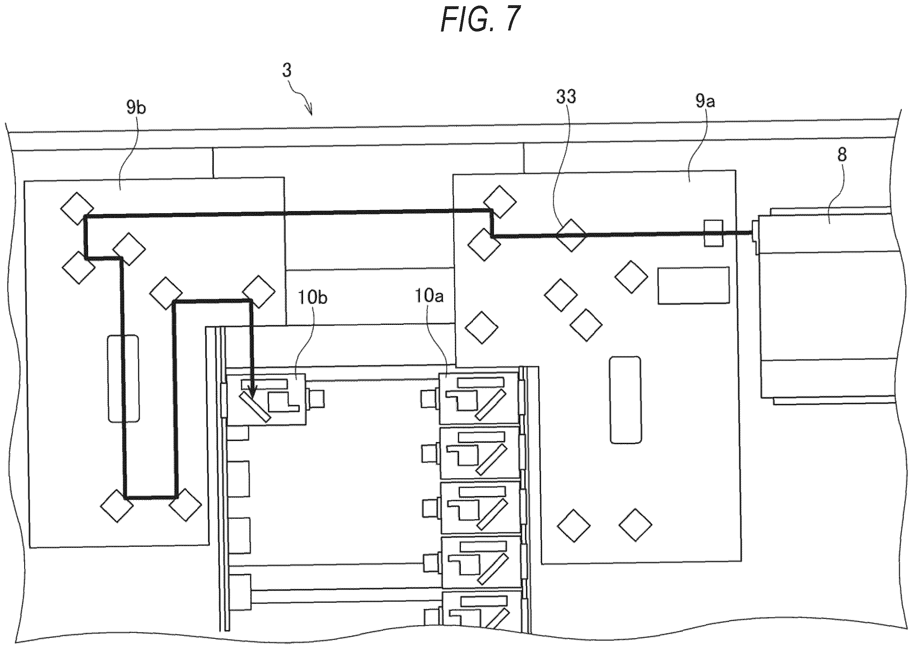

FIG. 6 illustrates an optical path of the laser beam in a case where the laser device 3 performs the vertical processing. FIG. 7 illustrates an optical path of the laser beam in a case where the laser device performs the horizontal processing.

The vertical processing irradiation units 10a includes a plurality of axes. The vertical processing irradiation units 10a includes eight axes, in the present embodiment. Each of the eight-axis irradiation units 10a is configured to emit laser beam and efficiently perform vertical processing on the film 50, which is a workpiece. The eight-axis vertical processing irradiation units 10a are arranged in series with respect to the optical path. The laser beam is transmitted in order from the most upstream irradiation unit 10a to the most downstream irradiation unit 10a. The eight-axis irradiation units 10a are scattered in a direction (X-axis direction) intersecting the film conveyance direction (Y-axis direction). The eight-axis irradiation units 10a are configured to be individually moved in the same direction (X-axis direction) by the drive mechanism. The horizontal processing irradiation unit 10b is disposed at a position spaced apart from the irradiation units 10a. The eight-axis irradiation units 10a is configured to perform laser processing in the direction (X-axis direction) intersecting the film conveyance direction (Y-axis direction) with one-axis.

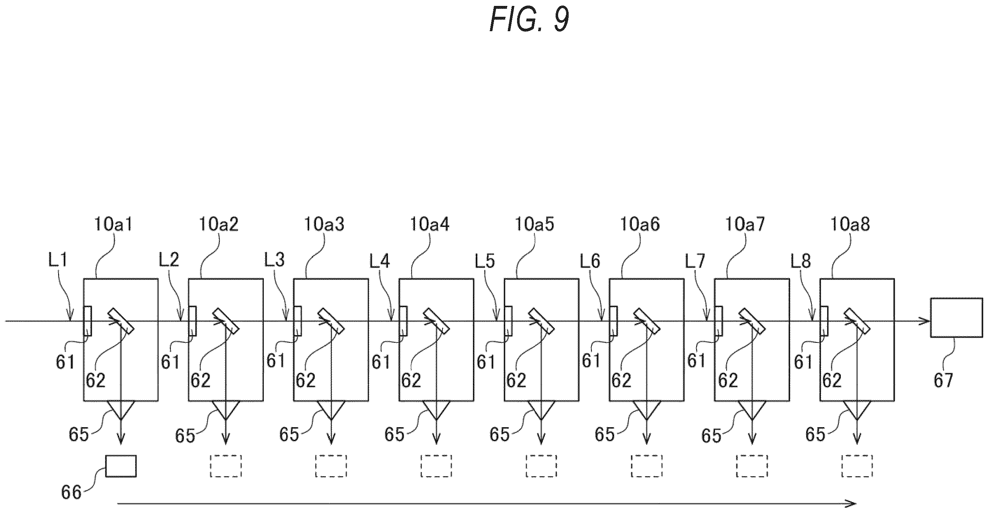

As illustrated in FIGS. 5 and 9, each of the irradiation units 10a includes a wave plate 61 with a rotation drive mechanism, a polarized beam splitter 62, a reflecting mirror 63 configured to reflect the laser beam and to convert an optical path, a camera 64 configured to capture an image of a processing line of a lower layer, and a processing nozzle 65. Since each of the irradiation units 10a includes the wave plate 61 and the polarized beam splitter 62, the power can be adjusted by adjusting the transmittance of the laser beam emitted from the processing nozzle 65. The laser device 3 is configured to substantially uniformly adjust a laser power to be output from each axis and to reduce variations in machining accuracy of each axis. Similar to the irradiation units 10a, the horizontal processing irradiation unit 10b also includes a wave plate 61 with a rotation drive mechanism, a polarized beam splitter 62, a reflecting mirror 63 configured to reflect the laser beam and to convert an optical path, a camera 64 configured to capture an image of a processing line of a lower layer, and a processing nozzle 65.

The laser device 3 may further include one or more power meters configured to measure the power of the laser beam emitted from the processing nozzle 65 for vertical processing, a beam damper configured to absorb excess laser beam emitted from the most downstream irradiation unit 10a, and a power meter configured to measure the power of the laser beam emitted from the processing nozzle 65 for horizontal processing.

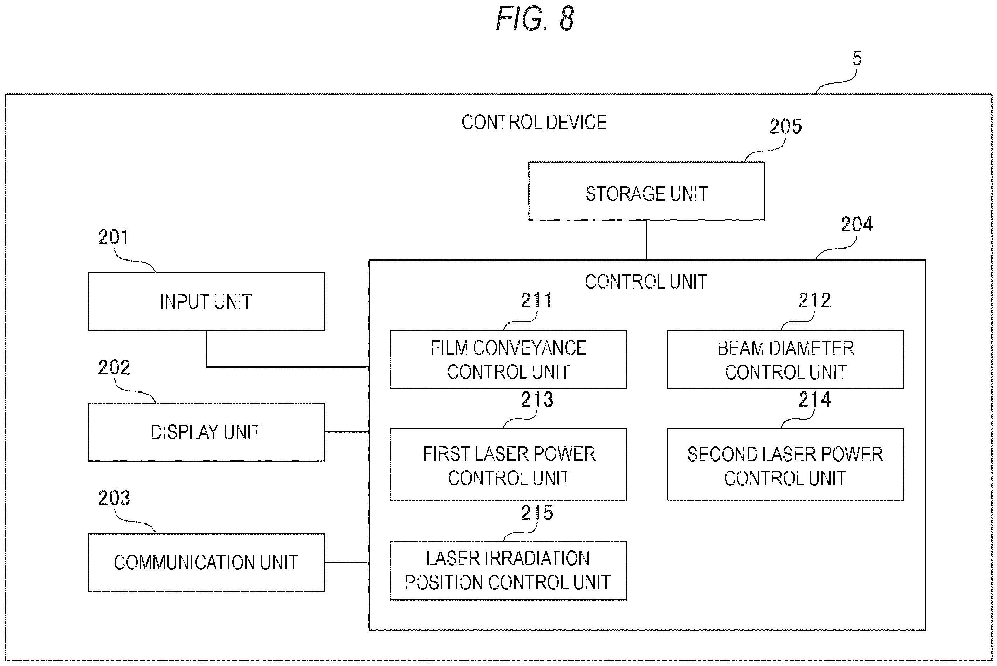

FIG. 8 is a functional block diagram illustrating a configuration of the control device 5. As illustrated in FIG. 8, the control device 5 includes an input unit 201, a display unit 202, a communication unit 203, a controller 204, and a storage unit 205. Specifically, the control device 5 is a computer system including hardware resources such as a central processing unit (CPU), a read only memory (ROM), a random access memory (RAM), a hard disk drive (HDD), a solid state drive (SSD), a display unit, a communication interface, and input devices such as a keyboard and a mouse. The control device 5 is configured to control each device provided in the laser processing machine 1.

The input unit 201 is an input device configured to receive user operations, such as a keyboard, a mouse, and various switches. Data input via the input unit 201 is stored in the storage unit 205.

The display unit 202 includes a display unit, a video codec, a graphics processing unit (GPU), a memory for screen data, and the like. The display unit 202 is configured to generate a UI screen and the like, and configured to display the UI screen and the like on the display unit. In a state where the UI screen is displayed on the display unit 202, the user may input information related to the film 50, laser processing conditions, various parameters of the laser oscillator 8, and the like via the input unit 201.

The communication unit 203 is configured to perform information communication with the unwinding device 2, the laser device 3, and the winding device 4 which are connected in a wireless or wired manner.

The controller 204 includes a CPU and a RAM as a working memory. The storage unit 205 is a so-called auxiliary storage device. The storage unit 205 is implemented by a non-volatile memory such as an HDD, an SSD, a read only memory (ROM), or a flash memory. The storage unit 205 is configured to store a computer program for controlling the laser processing machine 1 and various data input via the input unit 201. The CPU of the controller 204 is configured to load the computer program stored in the storage unit 205 in the RAM as a working memory, and to execute the computer program to control the unwinding device 2, the laser device 3, and the winding device 4 to perform patterning processing of the film 50.

The controller 204 includes, as functional configurations, a film conveyance controller 211, a beam diameter controller 212, a first laser power controller 213, a second laser power controller 214, and a laser irradiation position controller 215.

The film conveyance controller 211 has a function of conveying the film 50 by controlling the unwinding device 2, the holding table 6, and the winding device 4. In particular, in a case where the laser processing machine 1 performs vertical processing, the film conveyance controller 211 causes the film 50 to reciprocate.

The beam diameter controller 212 is configured to control the beam expander 35a of the vertical processing beam transmission unit 9a to adjust the laser beam to the collimated beam at a predetermined distance. Here, the "predetermined distance" is preferably the same distance as a distance from a condenser lens of the processing nozzle 65 provided in the most upstream irradiation unit 10a to a condenser lens of the processing nozzle 65 provided in the most downstream irradiation unit 10a.

Further, the beam diameter controller 212 is configured to control the beam expander 35b of the horizontal processing beam transmission unit 9b to adjust the laser beam to the collimated beam at a predetermined distance. At this time, a laser diameter may be measured using a profiler (not illustrated) or the like. The "predetermined distance" is preferably the same distance as a distance by which the irradiation unit 10b is configured to be moved. In a case where the control device 5 cannot automatically adjust positions of the beam expander 35a and the beam expander 35b, the user may manually adjust positions of the various lenses provided in the beam expander 35a and the beam expander 35b.

The first laser power controller 213 is configured to control the attenuator 32 to adjust an output of the main laser beam to be spatially transmitted. In the case of the vertical processing, a total output required for each axis is calculated by measuring the laser beam emitted from the most downstream irradiation unit 10a with the power meter. The attenuator 32 is adjusted so as to secure an output obtained by adding a value in consideration of an amount of attenuation caused by the optical components to the total output. In the case of the horizontal processing, the required output is calculated by measuring the laser beam emitted from the irradiation unit 10b at a time when the laser beam is transmitted to a processing end by the irradiation unit 10b with the power meter. The attenuator 32 is adjusted so that the calculated output can be secured.

The function of the second laser power controller 214 will be described with reference to FIG. 9. As illustrated in FIG. 9, the eight-axis irradiation units (irradiation unit 10a1 to irradiation unit 10a8) are arranged in series with respect to a laser beam L1, and thus a power of the laser beam to be input to each of the irradiation units 10a1, 10a2, ...attenuates in order of L1 > L2...> L8. Therefore, the second laser power controller 214 is configured to adjust an output by rotating the wave plate 61 such that the laser beam emitted from the processing nozzle 65 of each of the irradiation units 10a1, 10a2, ... has a substantially uniform output.

Further, the second laser power controller 214 is configured to measure the output of the laser beam emitted from each nozzle 65 with a power meter 66, and configured to perform feedback control of a rotation amount of an automatic rotation mechanism of the wave plate 61 using the measured value of the output. Here, each irradiation unit 10a is configured to perform reciprocating irradiation a predetermined number of times for processing one vertical processing line 52 (for example, about 20 reciprocations). In a case where the predetermined number of times of the reciprocating irradiation are finished, the laser irradiation position controller 215 to be described later controls the drive mechanism, such that each irradiation unit 10a moves in the Y-axis direction at a pitch of several millimeters. Accordingly, a processing position transitions in units of several millimeters.

The second laser power controller 214 is configured to perform the feedback control, whereby a laser output after the pitch feed movement can be adjusted to a predetermined value. The excess laser beam after the laser beam is emitted from the processing nozzle 65 of the most downstream irradiation unit 10a8 is received and absorbed by the beam damper 67. The excess laser beam is adjusted to be smaller when the first laser power controller 213 controls the attenuator 32. In FIG. 9, the output of the laser beam emitted from the eight-axis irradiation units 10a is measured while one power meter 66 is moved from upstream to downstream, and the number of power meters 66 may be two or more.

The laser irradiation position controller 215 has a function of controlling a laser irradiation position of each processing nozzle 65 such that each irradiation unit 10a follows the processing line of the lower layer. The memory of the controller 204 or the storage unit 205 is configured to store coordinate values indicating a design processing line in advance.

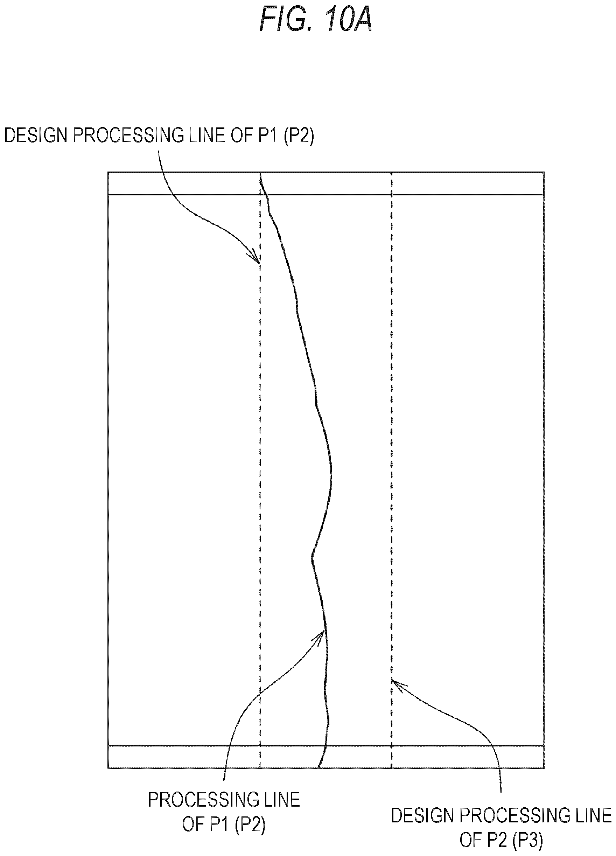

As indicated by broken lines in FIG. 10A, in a case where a design processing line of P1 (P2) and a design processing line of P2 (P3) are recorded, deformation of the film due to thermal influence in actual laser processing or individual characteristics of each processing nozzle are involved, and a processing line as indicated by a solid line can be obtained. Therefore, the laser irradiation position controller 215 captures an image of the processing line of the lower layer by the camera 64, and corrects the processing position based on the captured image data.

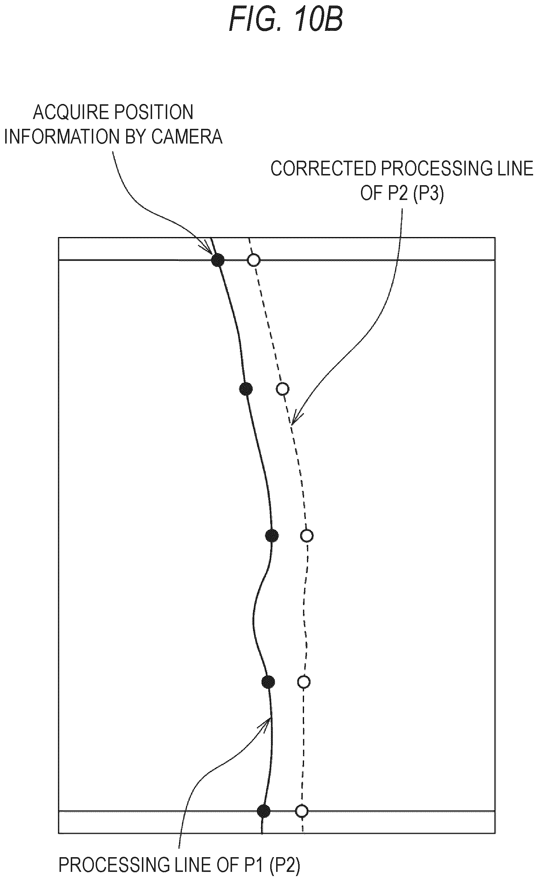

As illustrated in FIG. 10B, the laser irradiation position controller 215 is configured to acquire position information (coordinate values) at two or more points included in the processing line based on the image data captured by the camera 64. The set processing position is corrected using the acquired position information. In actual laser processing, a position of the processing nozzle 65 is adjusted by the drive mechanism such as the servo motor, or an angle of the laser beam emitted from the processing nozzle 65 is adjusted by using a tilt mirror (not illustrated), so that the corrected processing position is irradiated with the laser beam. The position of the processing nozzle 65 may be adjusted by the drive mechanism, and further the processing position may be precisely corrected using the tilt mirror.

### 2. Operation of Laser Processing Machine 1

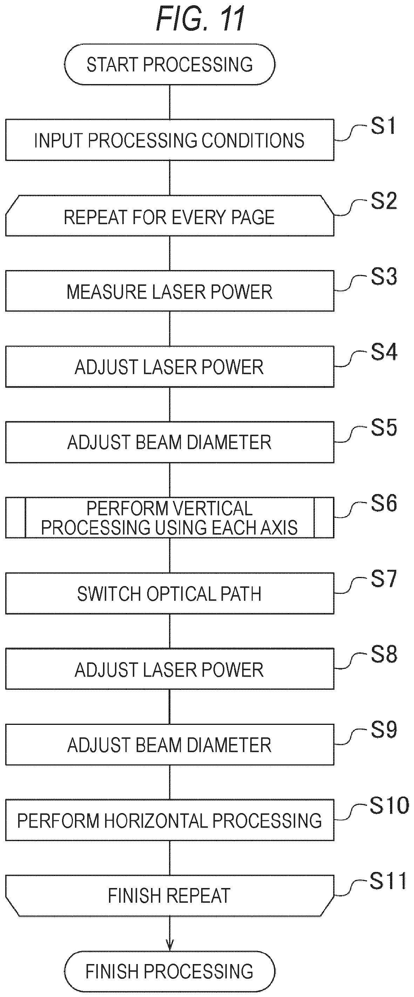

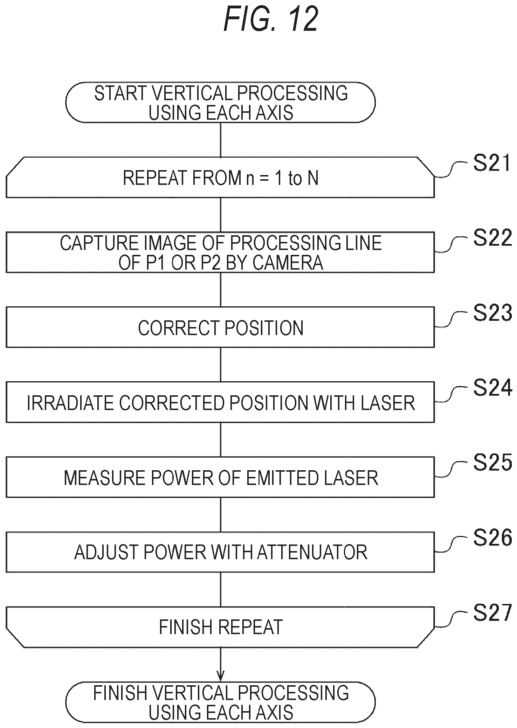

Next, the operation of the laser processing machine 1 will be described with reference to flowcharts of FIGS. 11 and 12.

First, various processing conditions are input via the input unit 201 of the control device 5 (step S 1). Next, step S2 to step S 11 are repeated for each page of the film to be processed 51.

The first laser power controller 213 of the control device 5 measures the laser power required in the vertical processing (step S3), and controls the attenuator 32 to adjust the laser power (step S4). Further, the beam diameter controller 212 of the control device 5 controls the beam expander 35a to adjust a beam diameter and generate collimated beam (step S5). Subsequently, the laser processing machine 1 spatially transmits the laser beam by the vertical processing beam transmission unit 9a, and performs processing of the vertical processing lines 52 using the eight-axis laser irradiation units 10a (step S6). When the vertical processing is finished, the control device 5 rotates the optical path switching mirror 33 so that the laser beam is incident on the horizontal processing beam transmission unit 9b to switch the optical path of the laser beam (step S7).

The first laser power controller 213 of the control device 5 measures the laser power required in the horizontal processing , and controls the attenuator 32 to adjust the laser power (step S8). Further, the beam diameter controller 212 of the control device 5 controls the beam expander 35b to adjust a beam diameter and generate collimated beam (step S9). The control device 5 moves the horizontal processing irradiation unit 10b in the Y-axis direction to emit the laser beam in the Y-axis direction, thereby processing the horizontal processing line 53 (step S10).

In a case where the horizontal processing is finished and the patterning processing for one page is completed (step S11), a next page of the film to be processed 51 is conveyed to the laser device 3, and the laser processing machine 1 returns to step S2 and continues the processing.

The laser power measurement, the laser power adjustment, and the beam diameter adjustment processing in steps S3 to S5 and steps S8 to S10 are not necessarily performed for every page.

FIG. 12 is a flowchart illustrating an operation of the vertical processing made by each axis of the eight-axis vertical processing irradiation units 10a. The operation is the details of step S6 in FIG. 11. Each irradiation unit 10a processes N vertical processing lines 52 while repeating the pitch feed movement in the Y-axis direction as described above. The laser processing machine 1 repeats the processes of step S21 to step S27 from n = 1 to n = N.

The laser irradiation position controller 215 captures an image of the processing line of the lower layer by the camera 64 (step S22). In a case where the laser processing machine 1 performs the P2 processing, the processing line of the P1 processing is imaged. In a case where the laser processing machine 1 performs the P3 processing, the processing line of the P2 processing is imaged. The laser irradiation position controller 215 corrects coordinates of a processing position set in advance using the captured image data (step S23).

The laser irradiation position controller 215 controls the drive mechanism or the tilt mirror such that the processing nozzle 65 of the irradiation unit 10a irradiates the corrected processing position with the laser beam (step S24). Subsequently, the output of the laser beam emitted from the processing nozzle 65 is measured by the power meter 66 (step S25), and the rotation amount of the wave plate 61 is feedback-controlled (step S26). In a case where each irradiation unit 10a finishes processing the N vertical processing lines 52 (step S27), the laser processing machine 1 finishes the vertical processing.

### 3. Effects of Embodiment

The laser processing machine 1 according to the present embodiment transmits the laser beam by using the space transmission method, and thus the optical path length from the laser oscillator 8 to the processing head of each of the irradiation units 10a and 10b becomes long. Therefore, there is concern about a decrease in beam quality, and in the present embodiment, the beam expander generates the collimated beam and the attenuator performs control so as to secure the required laser power, thereby preventing a decrease in beam quality.

Further, the laser processing machine 1 performs the processing by arranging the plurality of axes of the irradiation units 10a in series, and in order to keep the laser quality of each axis uniform, each of the plurality of irradiation units 10a is provided with the attenuator (wave plate with a rotation drive mechanism and polarized beam splitter) that controls the laser power, so that the laser quality of each axis can be kept approximately uniform.

### 4. Other Modifications

The foregoing description of the exemplary embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.
(1) In the above embodiment, the film 50 is supplied to the laser device 3 by a so-called Roll-to-Roll device, and the configuration is not essential. A supply form of the film may be a sheet form instead of a roll form. It is sufficient that there is a conveyance structure capable of causing the film to be processed to reciprocate without causing the irradiation units 10a themselves to reciprocate in at least the vertical processing performed by the laser device 3.
(2) In the above embodiment, there is a configuration that includes the plurality of irradiation units 10a that perform the vertical processing and the one irradiation unit 10b that performs the horizontal processing, and the configuration is not essential. For example, there may be a configuration in which the horizontal processing is performed using the plurality of vertical processing irradiation units 10a without including the horizontal processing irradiation unit 10b. In this case, the respective irradiation units 10a are operated simultaneously or at different times in a state in which the film is fixed. One horizontal processing line 53 may be processed by aligning a processing start position and a processing end position with each irradiation unit 10a.
(3) In the above embodiment, there is a configuration in which the horizontal processing is performed after the vertical processing, and the configuration is not essential. The laser processing machine 1 may perform the vertical processing after the horizontal processing.

## Claims

1. A space transmission device used in a laser processing machine, the laser processing machine including a laser oscillator configured to oscillate a laser beam having a pulse width in a picosecond order or a femtosecond order, and a plurality of irradiation units,
the space transmission device comprising:
an optical member configured to change a beam diameter of the laser beam, on an optical path of the laser beam that is emitted from the laser oscillator and that is incident on any one of the plurality of irradiation units.

2. The space transmission device according to claim 1,
wherein the optical member includes a plurality of lenses, and
the optical member is configured to generate collimated beam within a predetermined distance.

3. A laser processing machine comprising:
a laser oscillator configured to oscillate a laser beam having a pulse width in a picosecond order or a femtosecond order;
a plurality of first irradiation units configured to irradiate a workpiece with the laser beam; and
a beam transmission unit configured to spatially transmit the laser beam from the laser oscillator to the plurality of the first irradiation units,
wherein the beam transmission unit includes an optical member configured to change a beam diameter of the laser beam, on an optical path of the laser beam that is emitted from the laser oscillator and that is incident on any one of the plurality of the first irradiation units.

4. The laser processing machine according to claim 3, further comprising:
a drive mechanism configured to displace a position of the optical member; and
a beam diameter controller configured to control the drive mechanism to displace the position of the optical member to adjust, to a predetermined beam diameter, the beam diameter of the laser beam incident on any one of the plurality of the first irradiation units.

5. The laser processing machine according to claim 3,
wherein the beam transmission unit includes an attenuator configured to change a transmittance of the laser beam, on the optical path of the laser beam emitted from the laser oscillator and incident on any one of the plurality of the first irradiation units, and
the laser processing machine further comprises a first laser power controller configured to change a transmittance of the attenuator based on a total output of the laser beam required in the plurality of the first irradiation units to control a power of the laser beam to be transmitted.

6. The laser processing machine according to claim 3,
wherein each of the plurality of the first irradiation units includes:
a processing nozzle that faces the workpiece and that is configured to output the laser beam toward the workpiece; and
an adjustment mechanism configured to substantially uniformly adjust a power of the laser beam to be output from each processing nozzle,
wherein in particular each of the adjustment mechanisms includes a wave plate and a beam splitter, and
the laser processing machine further comprises:
at least one power meter configured to measure the power of the laser beam to be output from the respective processing nozzle of the plurality of the first irradiation units; and
a second laser power controller configured to control the wave plate and the beam splitter provided in each of the plurality of the first irradiation units, based on an output value of the laser beam measured by the power meter, to adjust a laser power of each the plurality of the first irradiation units.

7. The laser processing machine according to claim 3,
wherein the workpiece is a film formed by stacking a plurality of layers,
each of the plurality of the first irradiation units further includes a camera configured to capture an image of the film, and
the laser processing machine further comprises a laser irradiation position controller configured to determine a laser irradiation position of each of the plurality of the first irradiation units, based on a laser processing line of a lower layer included in an image captured by the camera.

8. The laser processing machine according to claim 7,
wherein the laser irradiation position controller includes a memory configured to store a predetermined laser irradiation position of each of the plurality of the first irradiation units in advance, and
the laser irradiation position controller is configured to correct the predetermined laser irradiation position stored in advance in the memory such that the predetermined laser irradiation position follows the laser processing line of the lower layer included in the image captured by the camera.

9. The laser processing machine according to claim 8,
wherein the plurality of the first irradiation units are scattered in a direction intersecting a film conveyance direction, and are configured to be individually moved in the same direction by the drive mechanism, and
the laser irradiation position controller is configured to control the drive mechanism such that each of the plurality of the first irradiation units processes the corrected laser irradiation position.

10. The laser processing machine according to claim 7,
wherein the plurality of the first irradiation units are scattered in a direction intersecting a scanning direction of the laser beam, and are configured to be moved in the same direction, and
each of the plurality of the first irradiation units is configured to perform a plurality of patterning processing parallel to the film conveyance direction on the film.

11. The laser processing machine according to claim 10, further comprising:
a second irradiation unit that is disposed at a position spaced apart from the plurality of the first irradiation units and is configured to perform patterning processing in the direction intersecting the film conveyance direction; and
a second beam transmission unit configured to spatially transmit the laser beam from the laser oscillator to the second irradiation unit.

12. The laser processing machine according to claim 11,
wherein the second beam transmission unit includes a second optical member configured to change a beam diameter of the laser beam, on an optical path of the laser beam emitted from the laser oscillator and incident on the second irradiation unit.

13. The laser processing machine according to claim 12, further comprising:
a drive mechanism configured to displace a position of the second optical member; and
a beam diameter controller configured to control the drive mechanism to displace the position of the optical member to adjust, to a predetermined beam diameter, the beam diameter of the laser beam incident on the second irradiation unit.

14. The laser processing machine according to claim 11, further comprising:
an optical path switching unit configured to guide the laser beam emitted from the laser oscillator to any one of the plurality of the first irradiation units or the second irradiation unit.

15. A space transmission method used in a laser processing machine, the laser processing machine including a laser oscillator configured to oscillate a laser beam having a pulse width in a picosecond order or a femtosecond order, and a plurality of irradiation units,
the space transmission method comprising:
changing a beam diameter of the laser beam, on an optical path of the laser beam emitted from the laser oscillator and incident on any one of the plurality of irradiation units.
